# FASCICULE DE BREVET EUROPEEN

(11) **EP 2 238 464 B1**
(45) Date de publication et mention de la délivrance du brevet: **27.03.2019**
(21) Numéro de dépôt: 08852564.7
(22) Date de dépôt: 18.11.2008
(51) Int. Cl.: G01D 1/16, G01R 19/25, G01R 19/257

(54) **MODULE D'ENTRÉES ANALOGIQUES POUR ÉQUIPEMENT D'AUTOMATISME**
ANALOGEINGABEMODUL FÜR AUTOMATISIERUNGSEINRICHTUNG
ANALOG INPUT MODULE FOR AUTOMATION EQUIPMENT

(30) Priorité: 22.11.2007 FR 0759213
(43) Date de publication de la demande: 13.10.2010
(73) Titulaire: Schneider Electric Industries SAS, 92500 Rueil-Malmaison (FR)
(72) Inventeur: GROSJEAN, Dominique, F-06650 Le Rouret (FR); BLANC, Christian, F-69290 Craponne (FR)
(74) Mandataire: Dufresne, Thierry
(86) Numéro de dépôt international: PCT/EP2008/065772
(87) Numéro de publication internationale: WO 2009/065837

(56) Documents cités:
- EP-A1- 1 114 377
- US-A1- 2004 254 754

## Description

La présente invention se rapporte à un module d'entrées analogiques pour équipement d'automatisme. Ce type de modules d'entrées analogiques est plus particulièrement employé dans un équipement d'automatisme de sécurité.

Un automate programmable ou PLC ("Programmable Logical Controller") est un équipement d'automatisme capable de piloter, commander et/ou surveiller un ou plusieurs process, notamment dans le domaine des automatismes industriels, du bâtiment ou de la distribution électrique.

De construction généralement modulaire, un automate programmable PLC est composé de différents modules qui communiquent entre eux par un bus de transmission, appelé généralement bus "fond de panier" (appelé aussi bus "backplane"). Les modules sont fixés mécaniquement dans un rack, lequel comprend un circuit imprimé qui supporte également le bus fond de panier ainsi que les éléments de connexion destinés à coopérer avec des connecteurs présents généralement sur la partie arrière des modules de manière à réaliser la liaison nécessaire entre les modules et le bus. Le nombre de modules dépend bien entendu de la taille et du type de process à automatiser.

Typiquement, un automate programmable peut comporter :
- un module d'alimentation fournissant les différentes tensions aux autres modules à travers le bus fond de panier,
- un module unité centrale UC qui comporte un logiciel embarqué ("firmware") intégrant un système d'exploitation OS temps réel, et un programme d'application, ou programme utilisateur, contenant les instructions à exécuter par le logiciel embarqué pour effectuer les opérations d'automatisme souhaitées. Le module UC comporte aussi généralement une connexion en face avant vers des outils de programmation de type ordinateur personnel PC.
- des modules d'entrées/sorties E/S de divers types en fonction du process à commander, tels que E/S numériques ou TOR, analogiques, de comptage, etc. Ces modules E/S sont reliés à des capteurs et des actionneurs participant à la gestion automatisée du process.
- un ou plusieurs modules de communication vers des réseaux de communication (Ethernet, CAN, ...) ou des interfaces homme-machine (écran, clavier,...).

A titre d'exemple, un module d'entrées/sorties peut comporter entre 1 à 32 voies E/S, un automate PLC pouvant être capable suivant les modèles de gérer plusieurs centaines de voies E/S. En cas de besoin, plusieurs racks sont donc connectés entre eux dans un même PLC.

Ainsi, en fonction de l'application et du process à automatiser, un automate PLC peut comporter un grand nombre de modules. C'est l'utilisateur de l'automate PLC qui décide donc du nombre et du positionnement des modules dans un rack, en fonction de son application.

Un module d'entrées analogiques d'un équipement d'automatisme comporte une ou plusieurs voies d'entrées et est doté, pour chaque voie de mesure, d'un circuit électronique d'acquisition de mesure. Le circuit électronique d'acquisition comporte notamment une résistance de mesure, dite résistance de précision.

Certains modules d'entrées analogiques sont employés dans des applications dites de sécurité et doivent donc garantir un certain niveau de sécurité. Pour garantir un certain niveau de sécurité dans les mesures effectuées par un module, il est nécessaire de pouvoir surveiller l'état de la résistance de mesure au cours du temps.

Le but de l'invention est donc de proposer un module d'entrées analogiques dans lequel il est possible de surveiller l'état de la résistance de mesure. Ce type de module est particulièrement adapté pour être employé dans des applications de sécurité.

Ce but est atteint par un module d'entrées analogiques pour équipement d'automatisme, ledit module comportant une ou plusieurs voies d'entrées, chaque voie comprenant un circuit électronique d'acquisition de mesure, ledit circuit électronique d'acquisition comprenant :
- au moins trois résistances arrangées entre elles de manière à définir deux points distincts de mesure de tension, l'une au moins des trois résistances étant une résistance de mesure,
- des moyens de mesure de tension aptes à mesurer deux tensions aux deux points de mesure de tension,
- des moyens de conversion des deux tensions mesurées en deux signaux numériques,
- des moyens de détermination d'un ratio entre les deux signaux numériques obtenus,
- des moyens de vérification de l'évolution du ratio obtenu entre les deux signaux par rapport à un ratio correspondant calculé à partir des valeurs de deux résistances connectées aux deux points de mesure de tension, afin de vérifier le fonctionnement de la voie d'entrée.

Le document US2004/254754 décrit notamment un convertisseur analogique/numérique comportant des premiers moyens de détection et des seconds moyens de détection. Les premiers moyens de détection comportent trois résistances en série et les seconds moyens de détection comportent deux résistances en série. Les premiers moyens de détection détectent une tension de sortie d'un capteur indiquant l'état d'un objet basé sur une tension source délivrée par une batterie. Les seconds moyens de détection détectent la tension source délivrée par la batterie. Cependant, par rapport à l'invention, les deux tensions sont envoyées sur deux entrées distinctes d'un convertisseur analogique/numérique afin de calculer une erreur de détection liées au procédé de fabrication du convertisseur sur PCB.

Selon un premier mode de réalisation de l'invention, le circuit électronique d'acquisition de mesure comporte quatre résistances, réparties sur deux branches en parallèle portant chacune deux résistances en série et en ce que les deux points de mesure de tension sont situés au point milieu de chaque branche.

Selon une particularité de ce second mode de réalisation, chaque branche du circuit électronique d'acquisition porte une résistance de mesure.

Selon une autre particularité de ce second mode de réalisation, le circuit électronique d'acquisition de mesure comporte des moyens de détermination d'un signal d'entrée par addition des deux signaux numériques obtenus.

Selon un second mode de réalisation de l'invention, le circuit d'acquisition comporte trois résistances montées en série et les deux points de mesure de tension sont situés entre une première résistance et une seconde résistance et entre la seconde résistance et une troisième résistance.

Selon l'invention, le module comprend deux canaux de mesure associés chacun à un point de mesure de tension. Les moyens de conversion comprennent alors un convertisseur analogique-numérique pour chaque canal de mesure.

L'invention concerne également un équipement d'automatisme comportant un module d'entrées analogiques tel que défini ci-dessus.

D'autres caractéristiques et avantages vont apparaître dans la description détaillée qui suit en se référant à un mode de réalisation donné à titre d'exemple et représenté par les dessins annexés sur lesquels :
- la figure 1 représente fonctionnellement une première variante de réalisation d'un circuit électronique d'acquisition de mesure employé dans un module d'entrées analogiques,
- la figure 2 représente fonctionnellement une seconde variante de réalisation d'un circuit électronique d'acquisition de mesure employé dans un module d'entrées analogiques.

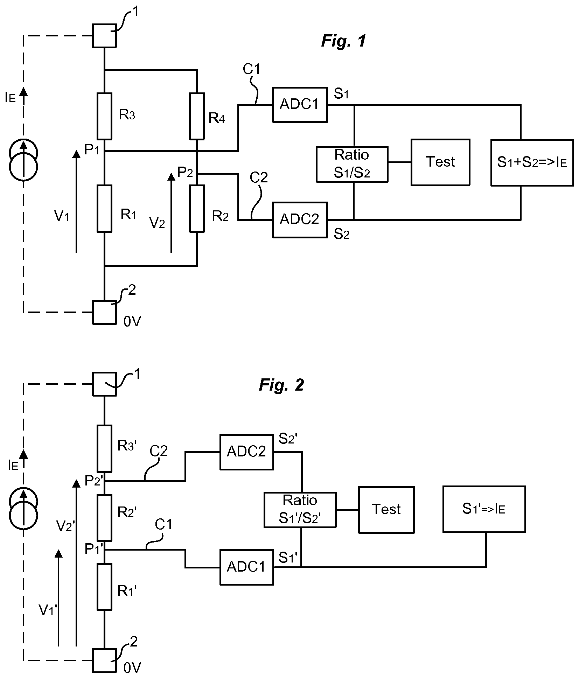

Un module d'entrées analogiques comporte typiquement une ou plusieurs voies d'entrées se présentant sous la forme de bornes distinctes sur lesquelles sont par exemple connectés des capteurs. Un capteur est ainsi connecté sur chaque voie du module entre une borne d'entrée 1 et un point de référence 2 (0 Volt), le point de référence 2 pouvant être commun à toutes les voies du module. Lorsque le module comporte des voies d'entrées analogiques, il reçoit donc d'un capteur un signal représentatif d'une mesure se présentant sous la forme d'un courant électrique d'entrée I_{E}. Sur les figures 1 et 2, la partie capteur est représentée en pointillés et est schématisée sous la forme d'un générateur de courant créant le courant d'entrée I_{E}.

Pour chaque voie d'entrée du module, le module comporte un circuit électronique d'acquisition de mesure permettant notamment de traiter et d'interpréter le courant d'entrée I_{E} reçu du capteur. Pour cela, le circuit électronique d'acquisition de chaque voie comporte une résistance de mesure afin de générer une tension mesurable à partir du courant d'entrée I_{E}. Cette résistance de mesure est une résistance de précision qui permet d'obtenir une grande précision dans la mesure du courant d'entrée.

L'invention consiste à pouvoir surveiller l'évolution de la résistance de mesure au sein du circuit électronique d'acquisition. Pour cela, le circuit électronique d'acquisition comporte au moins trois résistances arrangées entre elles de manière à définir deux points de mesure de tension distincts.

Selon l'invention, les deux tensions mesurées sont toutes les deux dépendantes de la valeur du même courant, c'est-à-dire de la valeur du courant d'entrée.

Dans une première variante de réalisation représentée en figure 1, le circuit électronique d'acquisition de mesure comporte un pont de résistances disposé entre la borne d'entrée 1 et le point de référence 2. Ce pont de résistances comporte deux branches de circuits montées en parallèle sur chacune desquelles sont montées deux résistances en série (R1, R2, R3, R4). Chacune des deux branches comporte une résistance de mesure R1, R2 et une autre résistance R3, R4. Avec un tel arrangement, on crée ainsi deux points P1, P2 distincts de mesure de tension situés chacun au point milieu d'une branche du pont de résistance. Ainsi, grâce à des moyens de mesure de tension, on mesure une première tension V1 aux bornes de la première résistance de mesure R1 et une seconde tension V2 aux bornes de la seconde résistance de mesure R2. Les deux tensions V1, V2 mesurées sont ensuite traitées via deux canaux de mesure différents C1, C2. Chaque canal de mesure C1, C2 comporte un convertisseur analogique-numérique ADC1, ADC2 permettant de convertir la tension mesurée V1, V2 sur chaque branche en un signal numérique S1, S2. Les deux signaux numériques S1, S2 obtenus en sortie des convertisseurs analogique-numérique ADC1, ADC2 sont ensuite traités par des moyens de traitement du module analogique. Les moyens de traitement calculent le ratio S1/S2 entre les deux signaux numériques S1, S2 obtenus et vérifient si ce ratio S1/S2 évolue au cours du temps par rapport à un ratio calculé entre les valeurs de deux résistances connectées chacune à un point P1, P2 de mesure de tension et égal à R1/R2. Toute évolution du ratio S1/S2 signifie que l'une des résistances R1, R2, R3, R4 du pont de résistances présente un défaut. En effet, si une des résistances R1, R2, R3, R4 d'une branche du pont se dégrade, la tension aux bornes de cette résistance évolue ce qui se répercute sur la valeur du ratio S1/S2 calculée. Tant que la valeur du ratio S1/S2 est constante et égale au ratio R1/R2 entre les résistances, cela signifie que les résistances du pont de résistances, et notamment les deux résistances de mesure R1, R2, sont toujours en parfait état de marche et donc que la mesure du courant d'entrée I_{E} est correcte. Bien entendu, il est envisageable que deux défauts présents en même temps sur les résistances se compensent et que le ratio calculé ne varie pas malgré ces deux défauts. Cependant cette dernière situation est très improbable, d'autant plus que les résistances R1 et R2 ne sont pas du même type que les résistances R3, R4 et qu'elles présentent des valeurs différentes.

Par ailleurs, dans cette première variante de réalisation, afin de reconstituer l'image du courant d'entrée I_{E}, les moyens de traitement additionnent les deux signaux numériques S1, S2 obtenus dans chaque canal de mesure C1, C2.

Dans une deuxième variante de réalisation représentée en figure 2, le circuit électronique d'acquisition de mesure comporte trois résistances R1', R2', R3' montées en série entre la borne d'entrée 1 et le point de référence 2. Cette variante de réalisation n'utilise qu'une seule résistance de mesure R1' puisque les résistances sont montées en série. Un premier point P1' de mesure de tension est définie sur le circuit entre la résistance de mesure R1' et une seconde résistance R2' et un second point P2' de mesure de tension est définie entre la seconde résistance R2' et une troisième résistance R3'. A l'aide des moyens de mesure de tension, on mesure une première tension V1' aux bornes de la résistance de mesure R1' et une seconde tension V2' aux bornes de la résistance de mesure R1' et de la seconde résistance R2'. Comme précédemment, les deux tensions V1', V2' mesurées sont traitées dans deux canaux de mesure C1, C2 distincts portant chacun un convertisseur analogique-numérique ADC1, ADC2. Les deux tensions mesurées V1', V2' sont alors converties en deux signaux numériques S1', S2' par les convertisseurs ADC1, ADC2. Les moyens de traitement calculent ensuite le ratio S1'/S2' entre les deux signaux numériques S1', S2' obtenus et vérifient l'évolution de ce ratio au cours du temps par rapport à un ratio correspondant calculé à partir des valeurs de deux résistances connectées aux deux points P1', P2' de mesure de tension et égal à R1'/(R1'+R2'). Si le ratio S1'/S2' évolue par rapport au ratio R1'/(R1'+R2'), cela signifie que la valeur de l'une des résistances du circuit d'acquisition a évolué. En revanche si le ratio est constant et correspond toujours à R1'/(R1'+R2'), cela signifie que les résistances sont toujours en parfait état de marche et donc que la mesure du courant d'entrée I_{E} est correcte.

En revanche, dans cette seconde variante de réalisation, contrairement à précédemment, l'image du courant d'entrée I_{E} n'a pas à être reconstitué car la mesure de la tension V1' aux bornes de la résistance de mesure R1' et le signal S1' obtenu suffisent pour avoir une image du courant d'entrée I_{E}.

Bien entendu, dans les deux variantes de réalisation décrites ci-dessus, pour surveiller l'état des résistances, il est tout à fait possible de vérifier un ratio différent à partir des mesures de tension réalisées aux bornes d'autres résistances que R1, R2, R1' et R2'.

## Revendications

1. Module d'entrées analogiques pour équipement d'automatisme, ledit module comportant une ou plusieurs voies d'entrées, chaque voie comprenant un circuit électronique d'acquisition de mesure, ledit circuit électronique d'acquisition comprenant :
- au moins trois résistances (R1, R2, R3, R4, R1', R2', R3') arrangées entre elles de manière à définir deux points (P1, P2, P1', P2') distincts de mesure de tension, l'une au moins des trois résistances étant une résistance de mesure,
- des moyens de mesure de tension aptes à mesurer deux tensions aux deux points (P1, P2, P1', P2') de mesure de tension,
- des moyens de conversion (ADC1, ADC2) des deux tensions mesurées en deux signaux numériques (S1, S2, S1', S2'),
- des moyens de vérification d'un ratio entre les deux signaux numériques (S1, S2, S1', S2') par rapport à un ratio correspondant calculé à partir des valeurs de résistances (R1, R2, R3, R4, R1', R2', R3') connectées aux deux points (P1, P2, P1', P2') de mesure de tension obtenues, afin de vérifier le fonctionnement de la voie d'entrée, une évolution dudit ratio signifiant que l'une des résistances présente un défaut.

2. Module selon la revendication 1, **caractérisé en ce que** le circuit électronique d'acquisition de mesure comporte trois résistances (R1', R2', R3') montées en série et **en ce que** les deux points (P1', P2') de mesure de tension sont situés entre une première résistance (R1') et une seconde résistance (R2') et entre la seconde résistance (R2') et une troisième résistance (R3').

3. Module selon la revendication 1, **caractérisé en ce que** le circuit électronique d'acquisition de mesure comporte quatre résistances (R1, R2, R3, R4), réparties sur deux branches en parallèle portant chacune deux résistances en série et **en ce que** les deux points (P1, P2) de mesure de tension sont situés au point milieu de chaque branche.

4. Module selon la revendication 3, **caractérisé en ce que** chaque branche porte une résistance de mesure (R1, R2).

5. Module selon la revendication 3 ou 4, **caractérisé en ce que** le circuit électronique d'acquisition de mesure comporte des moyens de détermination d'un signal d'entrée (I_{E}) par addition des deux signaux numériques (S1, S2) obtenus.

6. Module selon l'une des revendications 1 à 5, **caractérisé en ce qu'**il comprend deux canaux (C1, C2) de mesure associés chacun à un point (P1, P2, P1', P2') de mesure de tension.

7. Module selon la revendication 6, **caractérisé en ce que** les moyens de conversion (ADC1, ADC2) comprennent un convertisseur analogique-numérique pour chaque canal de mesure (C1, C2).

8. Equipement d'automatisme, **caractérisé en ce qu'**il comporte un module d'entrées analogiques tel que défini dans l'une des revendications 1 à 7.

## Patentansprüche

1. Analog-Eingangsmodul für ein Automatisierungsgerät, wobei das Modul einen oder mehrere Eingangskanäle aufweist, wobei jeder Kanal eine elektronische Erfassungsschaltung zur Messung aufweist, wobei die elektronische Erfassungsschaltung aufweist:
- mindestens drei Widerstände (R1, R2, R3, R4, R1', R2', R3'), die derart untereinander angeordnet sind, um zwei verschiedene Punkte (P1, P2, P1', P2') zur Spannungsmessung zu definieren, wobei mindestens einer der drei Widerstände ein Messwiderstand ist,
- Mittel zur Spannungsmessung, die geeignet sind, zwei Spannungen an den zwei Punkten (P1, P2, P1', P2') zur Spannungsmessung zu messen,
- Mittel zum Umwandeln (ADC1, ADC2) der zwei gemessenen Spannungen in zwei digitale Signale (S1, S2, S1', S2'),
- Mittel zum Überprüfen eines Verhältnisses zwischen den zwei digitalen Signalen (S1, S2, S1', S2') mit einem entsprechenden Verhältnis, das ausgehend von den Werten der Widerstände (R1, R2, R3, R4, R1', R2', R3') berechnet ist, die mit den zwei erhaltenen Punkten (P1, P2, P1', P2') zur Spannungsmessung verbunden sind,
um das Funktionieren des Eingangskanals zu überprüfen, wobei eine Entwicklung des Verhältnisses bedeutet, dass einer der Widerstände einen Mangel aufweist.

2. Modul nach Anspruch 1, **dadurch gekennzeichnet, dass** die elektronische Erfassungsschaltung zur Messung drei Widerstände (R1', R2', R3') aufweist, die in Reihe geschaltet sind, und dadurch, dass die zwei Punkte (P1', P2') zur Spannungsmessung zwischen einem ersten Widerstand (R1') und einem zweiten Widerstand (R2') und zwischen dem zweiten Winderstand (R2') und einem dritten Widerstand (R3') angeordnet sind.

3. Modul nach Anspruch 1, **dadurch gekennzeichnet, dass** die elektronische Erfassungsschaltung zur Messung vier Widerstände (R1, R2, R3, R4) aufweist, die auf zwei parallelgeschalteten Zweigen aufgeteilt sind, die jeweils zwei in Reihe geschaltete Widerstände tragen, und dadurch, dass die zwei Punkte (P1, P2) zur Spannungsmessung am Mittelpunkt von jedem Zweig angeordnet sind.

4. Modul nach Anspruch 3, **dadurch gekennzeichnet, dass** jeder Zweig einen Messwiderstand (R1, R2) aufweist.

5. Modul nach Anspruch 3 oder 4, **dadurch gekennzeichnet, dass** die elektronische Erfassungsschaltung zur Messung Mittel zum Bestimmen eines Eingangssignals (I_{E}) durch Addition der zwei erhaltenen digitalen Signale (S1, S2) aufweist.

6. Modul nach einem der Ansprüche 1 bis 5, **dadurch gekennzeichnet, dass** es zwei Messkanäle (C1, C2) aufweist, die jeweils einem Punkt (P1, P2, P1', P2') zur Spannungsmessung zugeordnet sind.

7. Modul nach Anspruch 6, **dadurch gekennzeichnet, dass** die Mittel zum Umwandeln (ADC1, ADC2) einen Analog-Digital-Wandler für jeden Messkanal (C1, C2) aufweisen.

8. Automatisierungsgerät, **dadurch gekennzeichnet, dass** es ein Analog-Eingangsmodul, wie in einem der Ansprüche 1 bis 7 definiert, aufweist.

## Claims

1. Analogue input module for an automation device, said module including one or more input channels, each channel comprising an electronic measurement acquisition circuit, said electronic acquisition circuit comprising:
- at least three resistors (R1, R2, R3, R4, R1', R2', R3') arranged with respect to one another so as to define two separate voltage measurement points (P1, P2, P1' P2'), at least one of the three resistors being a measurement resistor,
- voltage measurement means able to measure two voltages at the two voltage measurement points (P1, P2, P1', P2'),
- conversion means (ADC1, ADC2) for converting the two measured voltages into two digital signals (S1, S2, S1', S2'),
- checking means for checking a ratio between the two digital signals (S1, S2, S1', S2') with respect to a corresponding ratio calculated from the values of resistors (R1, R2, R3, R4, R1', R2', R3') connected to the two obtained voltage measurement points (P1, P2, P1', P2') so as to check that the input channel is functioning, a change in said ratio meaning that one of the resistors is faulty.

2. Module according to Claim 1, **characterized in that** the electronic measurement acquisition circuit includes three resistors (R1', R2', R3') connected in series, and **in that** the two voltage measurement points (P1', P2') are situated between a first resistor (R1') and a second resistor (R2') and between the second resistor (R2') and a third resistor (R3').

3. Module according to Claim 1, **characterized in that** the electronic measurement acquisition circuit includes four resistors (R1, R2, R3, R4), distributed over two branches in parallel, each bearing two resistors in series, and **in that** the two voltage measurement points (P1, P2) are situated at the centre tap of each branch.

4. Module according to Claim 3, **characterized in that** each branch bears a measurement resistor (R1, R2).

5. Module according to Claim 3 or 4, **characterized in that** the electronic measurement acquisition circuit includes means for determining an input signal (I_{E}) by adding the two obtained digital signals (S1, S2).

6. Module according to one of Claims 1 to 5, **characterized in that** it comprises two measurement channels (C1, C2) each associated with a voltage measurement point (P1, P2, P1', P2').

7. Module according to Claim 6, **characterized in that** the conversion means (ADC1, ADC2) comprise an analogue-to-digital converter for each measurement channel (C1, C2).

8. Automation device, **characterized in that** it includes an analogue input module as defined in one of Claims 1 to 7.
